# EUROPÄISCHE PATENTSCHRIFT

(11) **EP 1 306 348 B1**
(45) Veröffentlichungstag und Bekanntmachung des Hinweises auf die Patenterteilung: **16.05.2007**
(21) Anmeldenummer: 01125193.1
(22) Anmeldetag: 24.10.2001
(51) Int. Cl.: B81B 3/00

(54) **Verfahren zur Herstellung einer Membransensoreinheit sowie Membransensoreinheit**
Method for the manufacture of a membrane sensor unit and membrane sensor unit
Procédé de fabrication d'une unité capteuse à mémbrane et unité capteuse à mémbrane

(43) Veröffentlichungstag der Anmeldung: 02.05.2003
(73) Patentinhaber: ROBERT BOSCH GMBH, 70442 Stuttgart (DE)
(72) Erfinder: Artmann, Hans, 71106 Magstadt (DE); Pannek, Thorsten, 70176 Stuttgart (DE)

(56) Entgegenhaltungen:
- WO-A-99/27325
- WO-A-03/016203
- DE-A- 19 754 513
- DE-A- 19 835 050
- DE-A- 19 961 578
- R. L. SMITH: "Applications of Porous Silicon to Microstructure Fabrication" THE ELECTROCHEMICAL SOCIETY PROCEEDINGS, Bd. 94-32, 10. Oktober 1994 (1994-10-10), Seiten 281-289, XP008001213 Pennington, NJ, USA

## Beschreibung

Die Erfindung betrifft ein Verfahren zur Herstellung einer Membransensoreinheit sowie eine Membransensoreinheit nach dem Oberbegriff des Anspruchs 1 bzw. 7.

### Stand der Technik

Verfahren zur Herstellung einer Membransensoreinheit mit einem Halbleitermaterialträger, bei welchem für die Ausbildung von Sensorelementstrukturen wenigstens eine flächige Membran und unter der Membran eine Isolationswanne zur thermischen Isolierung der Membran vorgesehen werden, sind bereits bekannt geworden. Sofern die Membransensoreinheit mehrere flächige Membranbereiche umfasst, sind diese regelmäßig voneinander durch Stege aus Material mit im Vergleich zur Membran und der lateralen Umgebung der Stege deutlich besseren Wärmeleiteigenschaften getrennt.

Die zur Zeit auf dem Markt befindlichen Membransensoren sind zumeist als Dünnschichtmembranen realisiert. Hierzu werden Schichtsysteme in Dicken zwischen einigen 10 nm und einigen Mikrometern auf einem Trägersubstrat abgeschieden und danach das Trägersubstrat in vorgegebenen Bereichen entfernt, um freitragende Membranbereiche zu erhalten. Im Membranzentrum werden dann beispielsweise Sensorelemente angebracht, die durch die freitragende Anordnung der Membran vom umgebenden Trägersubstrat thermisch entkoppelt sind, was für Temperatur- und Strömungssensoren erwünscht ist.

Zur Freilegung der Membran können zwei Methoden unterschieden werden:
1. Die Oberflächenmikromechanik (OMM), bei welcher im Allgemeinen eine Opferschicht verwendet wird, die vor der Membranabscheidung auf der Vorderseite eines Trägersubstrates aufgebracht wird. Die Opferschicht wird später von der Vorderseite des Sensors durch "Löseöffnungen" in der Membran entfernt, wodurch eine freitragende Struktur entsteht. Diese oberflächenmikromechanischen Verfahren sind auf Grund der Notwendigkeit von separaten Opferschichten vergleichsweise aufwendig.
2. Die Bulkmikromechanik, bei welcher die Membran durch einen Ätzschritt von der Rückseite des Trägersubstrates freigelegt wird, d.h. in dem z.B. durch die vollständige Dicke eines Wafers eine Öffnung geätzt wird.

Für viele Anwendungen sind Arrays (Gruppierungen) von Sensoren erforderlich. Hierzu werden mehrere gleiche Sensoren nebeneinander linear oder zweidimensional angeordnet. Handelt es sich um Thermosensoren müssen diese durch Wärmesenken von einander getrennt werden, um eine räumliche Auflösung des Messsignals möglich zu machen.

Für die Herstellung der Wärmesenken gibt es verschiedene Möglichkeiten. Häufig wird eine Schicht aus einem gut wärmeleitenden Material auf der Oberfläche der Membran abgeschieden und strukturiert, so dass die verbleibenden Strukturen des gut wärmeleitenden Material als Wärmesenken dienen.

Man kann die Membran jedoch auch wie oben beschrieben mit bulkmikromechanischen Prozessen so freilegen, dass zwischen einzelnen Membranbereichen Stege aus Bulkmaterial verbleiben. Bei bulkmikromechanischen Membransensoren wird üblicherweise die Membran von der Rückseite durch einen anisotropen Ätzprozess beispielsweise mit KOH (Kaliumhydroxid) freigelegt. Hierbei erfordert die Ätzung obgleich ihrer Anisotropie allerdings wesentlich mehr Platz auf der Rückseite des Substrats als für die eigentliche Membranstruktur nötig wäre. Dadurch ist mit diesem Prozess die Integrationsdichte begrenzt.

Im Beitrag "Smith: Applications of porous silicon to microstructure fabrication" (The Electrochemical Society Proceedings, Band 94-32, Seiten 281-289) werden Herstellungsverfahren von porösem Silizium und seine technologischen Anwendungen als ein geeignetes Material in Mikrostrukturen beschrieben. Bei der Herstellung von porösem Silizium wird eine elektrochemische Reaktion zwischen Flusssäure und Silizium genutzt, bei der eine schwammartige Struktur im Silizium erzeugt wird. Auf einem p-dotierten Siliziumsubstrat sind Bereiche mit n-dotiertem Silizium vorgesehen, so dass unter Anwendung eines elektrischen Stromes die nicht durch n-dotiertes Silizium abgedeckten Stellen des p-dotierten Siliziumsubstrates porös geätzt wird. Daraus resultiert eine obere Schicht, die aus Bereichen mit n-dotiertem Silizium und porösem Silizium besteht. Es ist jedoch nicht vorgesehen, dass die Bereiche mit n-dotiertem Silizium als Sensorelementstrukturen dienen.

Aus DE-199 61 578 A1 ist ein Sensor mit zumindest einer mikromechanischen Struktur auf Siliziumbasis bekannt, die in einem Sensorraum eines Grundwafers integriert ist und dabei eine den Grundwafer im Bereich des Sensorraumes abdeckenden Abdeckung aufweist. Für das dort beschriebene Herstellungsverfahren des Sensors besteht die Abdeckung aus einer für ein Ätzmedium und die Reaktionsprodukte transparenten ersten Schicht und einer darüber liegenden hermetisch dichtenden zweiten Schicht, wobei der Sensorraum im Herstellungsprozess mit z. B. porösem Oxid gefüllt und in einem späteren Prozess wieder entfernt wird. Der Sensor weist eine Membran mit n-dotiertem Silizium, das als eine Sensorelementstruktur dient, nicht auf.

Ein Verfahren zur Herstellung eines Membransensors wird in WO-99/27325 erläutert. Dabei wird eine dünne Schicht aus Siliziumcarbid oder Siliziumnitrid über einem in der Oberfläche des Substrats ausgebildeten Bereich aus porösem Silizium abgeschieden, und anschließend durch ein Trockenätzverfahren Öffnungen in dieser Siliziumcarbid- oder Siliziumnitridschicht gebildet. Über die Öffnungen kann dann in einem späteren Prozess die poröse Schicht mit einem geeigneten Lösungsmittel entfernt werden. Die Bildung verschiedener Abschnitte durch eine Dotierung vorgegebener Bereiche innerhalb der Membranschicht ist jedoch nicht bekannt.

Schließlich ist aus DE-197 54 513 A1 ein weiteres Verfahren zur Herstellung eines Sensors mit einer Mikrostruktur bekannt, bei der ein poröser Bereich im Grundmaterial der Mikrostruktur durch elektrochemisches Ätzen in einem Säurebad gebildet wird. Es ist jedoch auch in dieser Lehre eine Membran mit n-dotiertem Bereich zur Erzeugung einer Sensorelementstruktur nicht vorgesehen.

Das Dokument WO03/016203 wurde am 27. Februar 2003 veröffentlicht und beansprucht die Priorität vom 7. August 2001. Es veröffentlicht eine poröse Membranschicht mit einer Kavität darunter.

### Aufgabe und Vorteile der Erfindung

Der Erfindung liegt die Aufgabe zu Grunde, die Herstellung von Membransensoren im Hinblick auf Kosten und Integrationsdichte zu verbessern.

Diese Aufgabe wird durch die Merkmale des Anspruchs 1 und des Anspruchs 7 gelöst.

Die Erfindung geht zunächst von einem Verfahren zur Herstellung einer Membransensoreinheit mit einem Halbleitermaterialträger aus, bei welchem für die Ausbildung von Sensorelementstrukturen für wenigstens einen Sensor eine flächige Membran und eine Isolationswanne zur thermischen Entkopplung unter der Membran erzeugt wird. Unter dem Begriff Membran wird im Sinne der Erfindung nicht nur eine freitragende Schicht verstanden, sondern im einfachsten Fall auch eine Schicht, die über einem Isolationswannenbereich angeordnet ist, der aus vergleichsweise besser isolierendem Material besteht. Der Kern der Erfindung liegt nun darin, dass der Träger aus Halbleitermaterial in einem vorgegebenen Bereich, der Sensorelementstrukturen definiert, eine zum umgebenden Halbleitermaterial gezielt unterschiedliche Dotierung erhält, dass aus Halbleitermaterialabschnitten zwischen den durch Dotierung ausgezeichneten Bereichen poröses Halbleitermaterial erzeugt wird, und dass Halbleitermaterial im Wannenbereich unter dem porösizierten Halbleitermaterial und unter Teilen der Sensorelementstrukturen entfernt und/oder porösiziert wird. Bei dieser Vorgehensweise wird die Erkenntnis ausgenutzt, dass poröses Halbleitermaterial mit einer deutlich größeren Oberfläche eine deutlich geringere Wärmeleitfähigkeit als Bulkhalbleitermaterial besitzt. Damit werden zum Beispiel nicht porösizierte Halbleitermaterialabschnitte innerhalb der Membran in lateraler Richtung durch das Membranmaterial thermisch isoliert. Eine Isolation eines derartigen Halbleiterbereichs nach unten wird durch den isolierenden Wannenbereich erreicht. Dieser kann entweder als Hohlraum oder selbst als porösiziertes Halbleitermaterial ausgebildet werden. Durch die erfindungsgemäßen Maßnahmen kann bis auf eine zweite Materialschicht zur Bildung eines Thermoelements die Membransensoreinheit vollständig aus dem Halbleiterträgermaterial erzeugt werden, was den Herstellungsprozess vereinfacht und die Herstellungskosten senkt.

Die geometrische Ausdehnung der Membransensorstrukturen lässt sich in einfacher Weise durch Dotierungsprozesse und gezielte Ätzprozesse kontrollieren, wodurch insbesondere die Thermokraft von Thermoelementen leicht einstellbar ist.

Bei der Herstellung von porösen Halbleitern, beispielhaft porösem Silizium, wird in der Regel eine elektrochemische Reaktion zwischen Flusssäure und Silizium genutzt, bei der eine schwammartige Struktur im Silizium erzeugt wird. Der Silizium-Halbleiterträger (in der Regel ein Siliziumwafer) muss hierzu gegenüber einem Flusssäureelektrolyt anodisch gepolt sein. Durch elektrochemisches Ätzen des Siliziums (Anodisieren) in beispielsweise einem Gemisch aus Flusssäure/Ethanol wird poröses Silizium durch teilweises Ätzen in die Tiefe erzeugt. Zum Ätzen von Silizium sind Defektelektronen (Löcher) an der Grenzfläche zwischen Silizium und Elektrolyt notwendig, die durch den fließenden Strom bereitgestellt werden. Ist die Stromdichte kleiner als eine kritische Stromdichte j_{KRIT},so diffundieren Löcher durch das anliegende elektrische Feld an in der Oberfläche liegende Vertiefungen, in denen ein bevorzugtes Ätzen stattfindet. Bei z.B. p-dotiertem Silizium werden die Bereiche zwischen den Vertiefungen bis zu einer minimalen Dicke lateral geätzt, bis durch Quanteneffekte keine Löcher mehr in diese Bereiche eindringen können und der Ätzvorgang gestoppt wird. Auf diese Weise entsteht eine schwammartige Skelettstruktur aus Silizium und freigeätzten Poren. Da bei der Ausbildung der Skelettstruktur der Ätzvorgang nur im Bereich der Porenspitzen stattfindet, bleibt die Schwammstruktur von bereits geätztem Silizium erhalten. Damit bleibt auch die Porengröße in den bereits geätzten Bereichen nahezu unverändert. Die Porengröße ist abhängig von der HF-Konzentration in der Flusssäure, der Dotierung und der Stromdichte und kann von einigen Nanometern bis zu einigen 10 nm betragen. Ebenso ist die Porösizität in einem Bereich von ca. 10 % bis über 90 % einstellbar.

Für die Herstellung von porösem Silizium können verschieden dotierte Substrate verwendet werden. Üblicherweise verwendet man p-dotierte Wafer mit unterschiedlichen Dotierungsgraden. Durch die Dotierung kann die Struktur innerhalb des porösen Siliziums bestimmt werden.

Für die lokale Herstellung des porösen Siliziums kann man sich die Erkenntnis zunutze machen, das p- und n-dotiertes Silizium ein stark unterschiedliches Ätzverhalten aufweisen. Unter den Bedingungen, bei denen im p-dotierten Silizium poröses Silizium erzeugt werden kann, ist dies in n-dotiertem Silizium nicht oder nur in einem sehr geringen Umfang möglich. Zur Festlegung der Sensorelementstrukturen kann daher eine Schicht an der Oberfläche des p-dotierten Substrats n-umdotiert werden (durch Ionenimplantationen oder Diffusion). Das poröse Silizium entsteht bei der elektrochemischen Ätzung nur in den p-dotierten Bereichen. Die Erzeugung von porösem Silizium kann auf die Dicke der n-umdotierten Schicht abgestimmt werden. Auf diese Weise erhält man eine Struktur, bei der zwischen n-umdotierten Bereichen eine porösizierte Siliziumschicht angeordnet ist.

In einer weiteren besonders bevorzugten Ausgestaltung der Erfindung wird das porösizierte Halbleitermaterial nach der Erzeugung des isolierenden Wannenbereichs oxidiert. Hierdurch wird die Wärmeleitfähigkeit der porösizierten Struktur weiter reduziert.

In einer überdies besonders bevorzugten Ausgestaltung der Erfindung werden die gezielt unterschiedlich dotierten Bereiche vor der Erzeugung von porösem, oxidiertem Halbleitermaterial mit einer Schutzschicht versehen. Beispielsweise wird bei einem Siliziumwafer das n-umdotierte Silizium zusätzlich mit einer Siliziumnitritschicht überzogen, die die n-umdotierten Bereiche schützt.

Vorzugsweise wird diese Passivierungsschicht nach der Erzeugung von porösem und gegebenenfalls oxidiertem Halbleitermaterial entfernt.

Der isolierende Wannenbereich kann in Form einer Kaverne oder als hochporöses Material ausgebildet werden.

In einer weiteren besonders vorteilhaften Ausgestaltung der Erfindung wird auf die durch Dotierung ausgezeichneten Halbleiterbereiche innerhalb des porösizierten und gegebenenfalls oxidierten Halbleitermaterials, die Sensorelementstrukturen ausbilden, d.h. Halbleiterbereiche an die zwar porösiziertes Material angrenzt, die aber selbst nicht porös sind, zur Erzeugung eines Thermoelements eine Materialschicht, zum Beispiel Aluminium aufgebracht. Die Erzeugung eines Thermoelements aus Halbleitermaterialbereichen, die zwischen porösiziertem und gegebenenfalls oxidiertem Halbleitermaterial angeordnet sind, lässt sich insbesondere dann durch einfaches Aufbringen einer weiteren Schicht realisieren, wenn bei der Erzeugung von porösem und gegebenenfalls oxidiertem Halbleitermaterial die durch Dotierung ausgezeichneten Halbleiterbereiche durch eine Passivierungsschicht geschützt werden. Denn nach Entfernen der Passivierungsschicht steht dann die gewünschte Halbleiteroberfläche (ohne zum Beispiel eine schädliche "Oxidhaut") für die Ausbildung eines Thermoelements zur Verfügung. Beispielsweise wird wie oben bereits erwähnt n-umdotiertes Silizium durch eine Siliziumnitritschicht geschützt, wobei nach Wegnahme der Siliziumnitritschicht das Thermoelement durch Aufbringen einer Aluminiumschicht erzeugt werden kann.

Im Weiteren geht die Erfindung von einer Membransensoreinheit mit einem Träger aus Halbleitermaterial aus, die zur Ausbildung von Sensorelementstrukturen für wenigstens einen Sensor eine Membran und eine unter der Membran angeordnete Isolationswanne zur thermischen Isolierung der Membran umfasst. Der wesentliche Aspekt der Membransensoreinheit liegt darin, dass die Membran Halbleitermaterialabschnitte aus porösiziertem und gegebenenfalls oxidiertem Halbleitermaterial umfasst. Hierdurch wird ein besonders einfacher Aufbau einer Membransensoreinheit, mit vergleichsweise guter thermischer Isolation eines Thermoelements ermöglicht.

Der Aufbau wird zusätzlich vereinfacht, wenn in der Membran nicht poröse und oxidierte Halbleiterbereiche angeordnet sind, die als Leiterbahnen bzw. Thermoschenkel für ein Thermoelement genutzt werden können. Wie bereits oben beschrieben, kann bei einem solchen Aufbau ein Thermoelement dann in einfacher Weise durch direkte Aufbringung einer weiteren Schicht mit entsprechender Strukturierung erzeugt werden.

Für die Anwendung als Thermoelement ist die Isolationswanne unter der Membran vorzugsweise als Kaverne ausgebildet. Für den Anwendungsbereich von Strömungssensoren ist die Isolationswanne dagegen bevorzugt als hochporöses Halbleitermaterial ausgestaltet.

Durch die exakte Erzeugung von porösem Halbleitermaterial und verbleibenden Halbleitermaterialbereichen lassen sich insbesondere mit oben beschriebenem Verfahren Membransensor-Arrays aufbauen, die eine hohe Integrationsdichte besitzen und dabei eine gute Trennung der einzelnen Membransensoreinheiten voneinander gewährleisten.

### Zeichnungen

Mehrere Ausführungsbeispiele der Erfindung sind in den Zeichnungen dargestellt und unter Angabe weiterer Vorteile und Einzelheiten näher erläutert.

Es zeigen
- Figur 1 a - c: in jeweils einem schematischen Schnittbild einen Siliziumträger bei der Herstellung eines Membransensors mit poröser Siliziummembran in unterschiedlichen Herstellungsstadien,
- Figur 2: das schematische Schnittbild eines Membransensors mit poröser Siliziummembran und darunter liegendem, isolierendem, porösem Wannenbereich und
- Figur 3: die schematische Draufsicht auf ein Membransensor-Array.

### Beschreibung der Ausführungsbeispiele

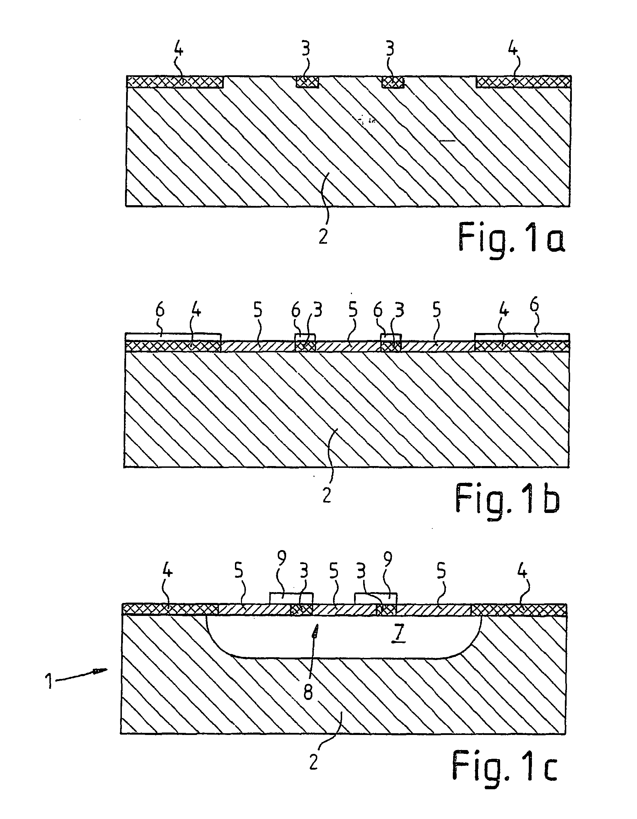

Figur 1a bis 1c zeigt in jeweils einem schematischen Schnittbild die Entstehung eines Membransensors 1 auf der Grundlage eines p-dotierten Silizumwafers 2.

In einem ersten Schritt werden zum Beispiel mittels Ionenimplantation n-dotierte Bereiche 3, 4 erzeugt, die später als Leiterbahnen und Thermoschenkel bzw. Sensorrand dienen sollen (siehe Figur 1a).

Die p (bevorzugt ≈ 0,02 Ωcm)-dotierten Bereiche des Silizumsubstrats 2 zwischen den Bereichen 3, 4 werden porösiziert und bilden mesoporöse Bereiche 5 (zum Beispiel Porösität 10 bis 65 %; Schichtdicke ≈ 1 bis 10 µm oder mehr; Stromdichte ≈ 1 bis 50 mA/cm²; HF-Konzentration ≈ 15 bis 40 %). Je nach Anwendung wird die Porösität der Bereiche 5 eingestellt (hohe Porösität > 55 % zur thermischen Entkopplung). Innerhalb der Bereiche 5 liegen die als Thermoschenkel dienenden n-dotierten Bereiche 3. Die n-dotierten Bereiche 3, 4 wurden vor der Erzeugung der porösen Bereiche 5 mit einer Siliziumnitritschicht 6 als Schutzschicht für den Vorgang der Porösizierung versehen. Diese Siliziumnitritschicht 6 wird nach der Porösizierung wieder entfernt.
Anschließend wird durch die porösen Bereiche hindurch durch geeignete Verfahren unterhalb der Bereiche 3, 5 eine Kaverne 7 erzeugt.

Dieser Ätzschritt kann durch Silizium-Gasphasenätzen durch die Poren der Bereiche 5 oder durch Elektropolitur (mit zum Beispiel HF-Konzentration 2 bis 20 %; Stromdichte > 50 mA/cm²) ebenfalls durch die Poren der Bereiche 5 erfolgen.

Der Ätzvorgang ist isotrop, so dass auch in lateraler Richtung ein Ätzen von p-dotiertem Halbleitermaterial auftritt. Auf diese Weise entsteht die in Figur 1c schematisch dargestellte durchgehende Kaverne 7 durch vollständige "Unterätzung" der n-dotierten Bereiche 3 und durch eine teilweise "Unterätzung" der n-dotierten Bereiche 4. Die Kaverne 7 wird dementsprechend durch die Bereiche 3, 4 und 5 abgedeckt, die eine Membran 8 ausbilden.

Um die mesoporösen Bereiche 5 zu stabilisieren und deren Warmleitfähigkeit noch weiter zu reduzieren, können diese zusätzlich oxidiert werden.

Zur Verbesserung der Langzeitstabilität der teilweise porösen Membran 8 kann diese durch eine CVD (Chemical Vapour Deposition)-Deckschicht versiegelt werden (nicht dargestellt). Vor oder nach der Erzeugung der Kaverne 7 mit entsprechender Unterätzung werden die für ein Thermoelement zusätzlich benötigten Strukturen, insbesondere die zweiten Thermoschenkel, erzeugt.

Für Temperatur- und Strömungssensoren 3 werden zum Beispiel auf den n-umdotierten Siliziumbereichen 3 Thermoschenkel 9 aus Aluminium oder p-dotiertem Poly-Silizium angeordnet.

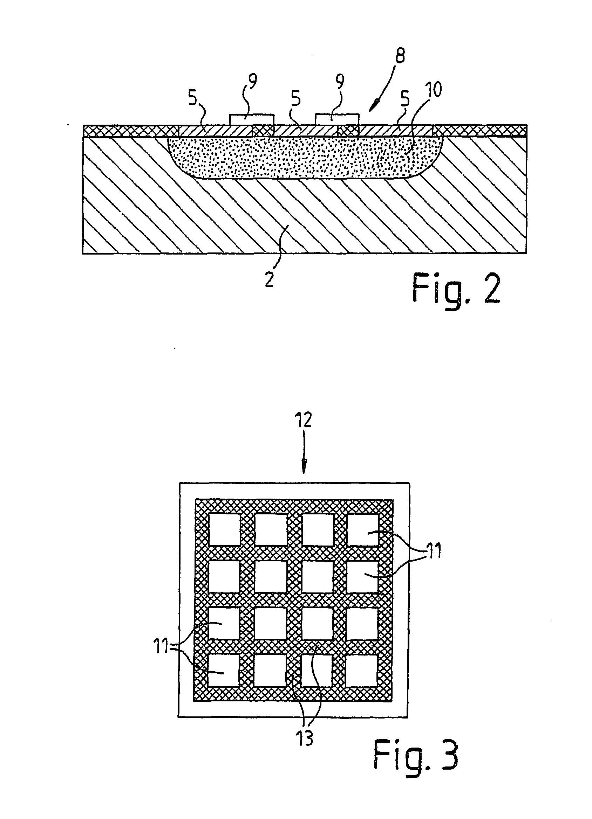

Insbesondere bei Strömungssensoren (siehe Figur 2) kann im Wannenbereich 10 unterhalb der Membran das Halbleitermaterial auch porösiziert und oxidiert werden. Vorzugsweise wird ein nanoporöser Siliziumbereich durch einen entsprechenden Ätzprozess durch die porösen Bereiche 5 hindurch geschaffen. In diesem Fall wird der Grad der Porösität vergleichsweise hoch (> 60 %) eingestellt, um die Masse an verbleibendem Silizium zu minimieren, aber dennoch eine ausreichende Stabilität zu gewährleisten. Das so erzeugte poröse Silizium im Wannenbereich 10 kann anschließend oxidiert werden, um das vergleichsweise gut wärmeleitende Silizium in schlechter wärmeleitendes poröses Siliziumoxid umzuwandeln. Die Wärmeleitfähigkeiten der einzelnen Materialien lassen sich wie folgt beziffern:
Silizium ≈ 150 W/Km
Siliziumoxid 1,4 W/Km
nano-porösiziertes Silizium 1 bis 2 W/Km
oxidiertes porösiziertes Silizium 0,3 bis 1,4 W/Km.

Um eine gute Wärmeisolation in Richtung Halbleiterträger 2 zu erzielen, wird die Dicke des Wannenbereichs 10 möglichst groß gewählt (zum Beispiel 50 bis 150 µm).

Durch das Aufbringen und Strukturieren (nasschemisch oder physikalisch/trockenchemisch) von CVD-(Chemical Vapour Deposition) beziehungsweise Sputter-Schichten kann eine Deckschicht zur Versieglung der Membran 8 und insbesondere der porösen Bereiche 5 sowie der Thermoschenkel 9, die das zweite thermoelektrische Element bilden, erzeugt werden.

Aufgrund der vergleichsweise guten Wärmeleitfähigkeit von monokristallinem Silizium können n- oder p-dotierte Siliziumbereiche dazu verwendet werden, Einzelpixel 11 von Sensor-Arrays 12 thermisch zu entkoppeln (siehe Figur 3).

Diese Entkopplung ist vor allem bei hochintegrierten Sensor-Arrays notwendig, um ein thermisches Übersprechen unter den einzelnen Pixeln 11 zu verhindern.

Entsprechend dem oben beschriebenen Verfahren ist es möglich, bei der Erzeugung der Membran 8 mit darunterliegendem Wannenbereich 7, 10 gleichzeitig die erforderlichen Wärmesenken 13 zu erzeugen. Damit können mit der erfindungsgemäßen Vorgehensweise insbesondere hochintegrierte Sensor-Arrays aufgebaut werden.

## Patentansprüche

1. Verfahren zur Herstellung einer Membransensoreinheit (1) mit einem Halbleitermaterialträger (2), bei welchem für die Ausbildung von Sensorelementstrukturen für wenigstens einen Sensor eine flächige Membran (8) mit einer konstanten Dicke und eine Isolationswanne (7, 10) zur thermischen Isolierung unter der Membran (8) erzeugt wird, **dadurch gekennzeichnet, dass** zur Erzeugung der Membran (8) eine Schicht an der Oberfläche des p-dotierten Trägers (2) in einem vorgegebenen Bereich, der Sensorelementstrukturen (3, 4) definiert, n- umdotiert wird, dass aus Halbleitermaterialabschnitten zwischen den durch Dotierung ausgezeichneten Bereichen (3, 4) poröses Halbleitermaterial (5) erzeugt wird, und dass das Halbleitermaterial im Wannenbereich (7, 10) unter dem porösiziertem Halbleitermaterial und Teilen der Sensorelementstruktur (3, 4) entfernt und/oder porösiziert wird.

2. Verfahren nach Anspruch 1, **dadurch gekennzeichnet, dass** das porösizierte Halbleitermaterial (5) nach der Erzeugung des isolierenden Wannenbereichs (7, 10) oxidiert wird.

3. Verfahren nach Anspruch 1 oder 2, **dadurch gekennzeichnet, dass** die gezielt unterschiedlich dotierten Bereiche (3, 4) vor der Erzeugung von porösem Halbleitermaterial mit einer Schutzschicht (6) versehen werden.

4. Verfahren nach einem der vorhergehenden Ansprüche, **dadurch gekennzeichnet, dass** der Wannenbereich (7) durch die porösen Membranabschnitte der Membran hindurch durch Ätzen entfernt wird.

5. Verfahren nach einem der vorhergehenden Ansprüche, **dadurch gekennzeichnet, dass** der Wannenbereich (7) durch die porösen Membranabschnitte der Membran hindurch porösiziert und gegebenenfalls oxidiert wird.

6. Verfahren nach einem der vorhergehenden Ansprüche, **dadurch gekennzeichnet, dass** auf die durch Dotierung ausgezeichneten Halbleiterbereiche (3, 4) innerhalb des porösizierten und gegebenenfalls oxidierten Halbleitermaterials (5), die Sensorelementstrukturen ausbilden, zur Erzeugung eines Thermoelements eine weitere Schicht (9) aufgebracht und strukturiert wird.

7. Membransensoreinheit mit einem Träger (2) aus Halbleitermaterial, die zur Ausbildung von Sensorelementstrukturen für wenigstens einen Sensor eine flächige Membran (8) mit einer konstanten Dicke und eine unter der Membran (8) angeordnete Isolationswanne (7, 10) zur thermischen Isolierung der Membran (8) umfasst, **dadurch gekennzeichnet, dass** die Membran (8) Halbleitermaterialabschnitte (5) aus porösiziertem und gegebenenfalls oxidiertem Halbleitermaterial und einen Bereich, der Sensorelementstrukturen (3, 4) definiert, umfasst.

8. Membransensoreinheit nach Anspruch 7, **dadurch gekennzeichnet, dass** in der Membran (8) zur Ausbildung von Leiterbahnen nicht poröse Halbleiterbereiche (3, 4) angeordnet sind.

9. Membransensoreinheit nach Anspruch 7 oder 8, **dadurch gekennzeichnet, dass** die Isolationswanne als Kaverne (7) ausgebildet ist.

10. Membransensoreinheit nach einem der Ansprüche 7 bis 9, **dadurch gekennzeichnet, dass** der Wannenbereich (10) hochporöses Halbleitermaterial umfasst.

11. Membransensorarray das mehrere Membransensoreinheiten (1) nach einem der vorhergehenden Ansprüche 7 bis 10 umfasst.

## Claims

1. Method for producing a membrane sensor unit (1) comprising a semiconductor material carrier (2), in which, for the formation of sensor element structures for at least one sensor, an areal membrane (8) having a constant thickness is produced and an insulation well (7, 10) for thermal insulation is produced below the membrane (8), **characterized in that**, for producing the membrane (8), a layer at the surface of the p-doped carrier (2) is n-redoped in a predetermined region that defines sensor element structures (3, 4), **in that** porous semiconductor material (5) is produced from semiconductor material sections between the regions (3, 4) distinguished by doping, and **in that** the semiconductor material in the well region (7, 10) below the porositized semiconductor material and parts of the sensor element structure (3, 4) is removed and/or porositized.

2. Method according to claim 1, **characterized in that** the porositized semiconductor material (5) is oxidized after the production of the insulating well region (7, 10).

3. Method according to Claim 1 or 2, **characterized in that** the regions (3, 4) which are doped differently in a targeted manner are provided with a protection layer (6) before the production of porous semiconductor material.

4. Method according to one of the preceding claims, **characterized in that** the well region (7) is removed by etching through the porous membrane sections of the membrane.

5. Method according to one of the preceding claims, **characterized in that** the well region (7) is porositized, and if appropriate oxidized, through the porous membrane sections of the membrane.

6. Method according to one of the preceding claims, **characterized in that** a further layer (9) is applied to the semiconductor regions (3, 4) distinguished by doping within the porositized and, if appropriate oxidized semiconductor material (5), which form sensor element structures, and is patterned for the purpose of producing a thermoelement.

7. Membrane sensor unit comprising a carrier (2) made of semiconductor material, which, for the formation of sensor element structures for at least one sensor, comprises an areal membrane (8) having a constant thickness and an insulation well (7, 10) for thermal insulation of the membrane (8), said insulation well being arranged below the membrane (8), **characterized in that** the membrane (8) comprises semiconductor material sections (5) made of porositized and, if appropriate, oxidized semiconductor material and a region that defines sensor element structures (3, 4).

8. Membrane sensor unit according to Claim 7,
**characterized in that** non-porous semiconductor regions (3, 4) are arranged in the membrane (8) for the purpose of forming interconnects.

9. Membrane sensor unit according to Claim 7 or 8, **characterized in that** the insulation well is formed as a cavity (7).

10. Membrane sensor unit according to one of Claims 7 to 9, **characterized in that** the well region (10) comprises highly porous semiconductor material.

11. Membrane sensor array comprising a plurality of membrane sensor units (1) according to one of the preceding Claims 7 to 10.

## Revendications

1. Procédé de fabrication d'une unité détectrice à membrane (1) comportant un substrat en matière semi-conductrice (2), selon lequel, pour former des structures d'éléments capteurs pour au moins un capteur on réalise une membrane plane (8) d'épaisseur constante et un puits isolant (7, 10) pour assurer l'isolation thermique sous la membrane (8),
**caractérisé en ce que**
pour réaliser la membrane (8) on effectue un dopage n sur une zone prédéterminée définissant des structures d'éléments capteurs (3, 4) sur une couche présente à la surface du substrat (2) à dopage p, on réalise une matière conductrice poreuse (5) à partir de segments de matière semi-conductrice entre les zones (3, 4) à dopage distinct, et on élimine et/ou on rend poreuse la matière semi-conductrice dans la zone de puits (7, 10) sous la matière semi-conductrice rendue poreuse et dans des parties de la structure d'élément de capteur (3, 4).

2. Procédé selon la revendication 1,
**caractérisé en ce qu'**
on oxyde la matière semi-conductrice (5) rendue poreuse après la réalisation de la zone de puits isolante (7, 10).

3. Procédé selon la revendication 1 ou 2,
**caractérisé en ce que**
les zones (3, 4) à dopage différent ciblé sont pourvues d'une couche protectrice (6) avant la réalisation de la matière semi-conductrice poreuse.

4. Procédé selon l'une quelconque des revendications précédentes,
**caractérisé en ce** qu*'
on élimine la zone de puits (7) par attaque chimique à travers les sections poreuses de la membrane.

5. Procédé selon l'une quelconque des revendications précédentes,
**caractérisé en ce que**
la zone de puits (7) est rendue poreuse et éventuellement oxydée à travers les sections poreuses de la membrane.

6. Procédé selon l'une quelconque des revendications précédentes,
**caractérisé en ce que**
pour réaliser un thermoélément, on dépose et on structure une couche supplémentaire (9) sur les zones semi-conductrices (3, 4) à dopage distinct qui à l'intérieur de la matière semi-conductrice (5) rendue poreuse et éventuellement oxydée, forment des structures d'éléments capteurs.

7. Unité détectrice à membrane comportant un substrat (2) en matière semi-conductrice, comprenant, pour former des structures d'éléments capteurs pour au moins un capteur, une membrane plane (8) d'épaisseur constante et un puits isolant (7, 10) disposé sous la membrane (8) pour assurer l'isolation thermique de la membrane (8),
**caractérisée en ce que**
la membrane (8) comprend des segments (5) de matière semi-conductrice rendue poreuse et éventuellement oxydée, et une zone définissant des structures d'éléments capteurs (3, 4).

8. Unité détectrice à membrane selon la revendication 7,
**caractérisée en ce que**
des zones semi-conductrices (3, 4) non poreuses sont prévues dans la membrane (8) pour former des pistes conductrices.

9. Unité détectrice à membrane selon la revendication 7 ou 8,
**caractérisée en ce que**
le puits d'isolation a la configuration d'une caverne (7).

10. Unité détectrice à membrane selon l'une quelconque des revendications 7 à 9,
**caractérisé en ce que**
la zone de puits (10) comprend une matière semi-conductrice hautement poreuse.

11. Réseau de capteurs à membrane comprenant plusieurs unités détectrices à membrane (1) selon l'une quelconque des revendications précédentes 7 à 10.
